# EUROPEAN PATENT SPECIFICATION

(11) **EP 2 914 073 B1**
(45) Date of publication and mention of the grant of the patent: **16.08.2017**
(21) Application number: 15154714.8
(22) Date of filing: 11.02.2015
(51) Int. Cl.: H05K 5/00

(54) **Electronic unit**
Elektronische Einheit
Unité électronique

(30) Priority: 27.02.2014 JP 2014036702
(43) Date of publication of application: 02.09.2015
(73) Proprietor: KABUSHIKI KAISHA TOYOTA JIDOSHOKKI, Kariya-shi, Aichi-ken, 448-8671 (JP)
(72) Inventor: Murata, Tatsuya, Kariya-shi, Aichi-ken, 448-8671 (JP)
(74) Representative: Winter, Brandl, Fürniss, Hübner, Röss, Kaiser, Polte - Partnerschaft mbB

(56) References cited:
- EP-A2- 0 484 289
- US-A- 5 709 557
- US-A1- 2008 045 061

## Description

### BACKGROUND OF THE INVENTION

The present invention relates to an electronic unit and more specifically to an electronic unit that is provided with a housing accommodating therein a circuit board and a connector having a lead wire which electrically connects the connector with the circuit board.

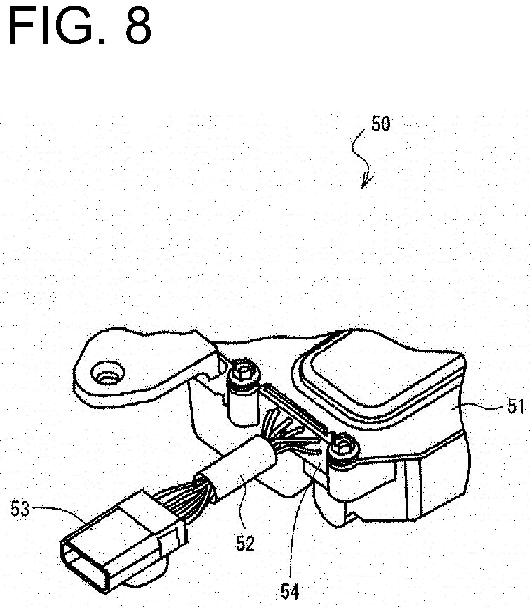

An electronic unit which is provided with a connector mounted on a printed circuit board disposed in the housing has a structure that prevents a wire from entering into the housing for preventing an electric shock. In a conventional electronic unit 50 as shown in Fig. 8, a connector 53 is connected to one end of a wire harness 52 the other end of which is connected to a circuit board (not shown) disposed in a housing 51 of the electronic unit 50. The wire harness 52 has therein a plurality of electric wires each of which is connected to the circuit board, and the housing 51 has therein a grommet 54 through which a plurality of holes is formed and the electric wires are inserted through these holes in the grommet 54 for protection of the wires.

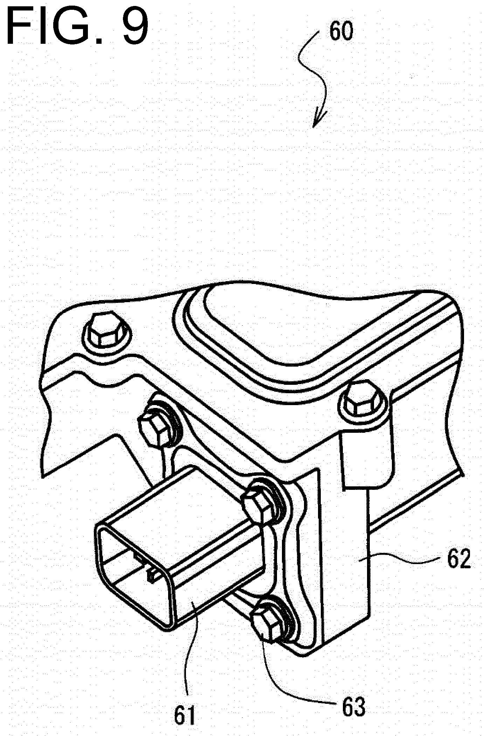

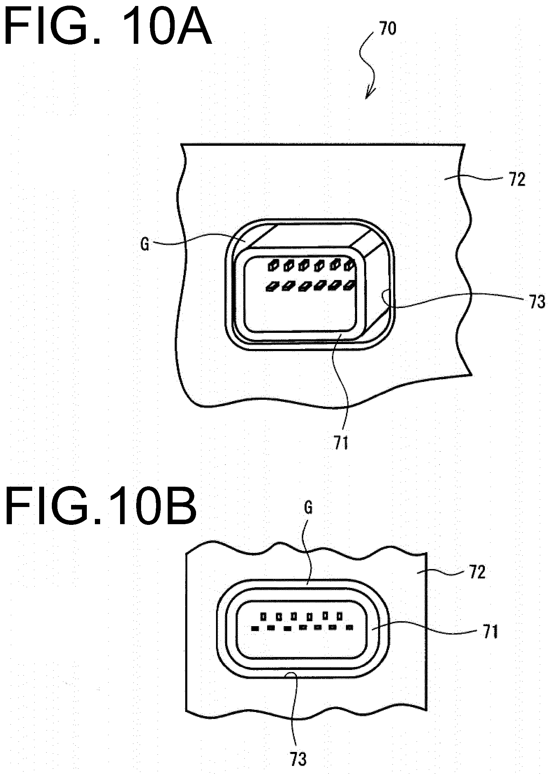

In another example of conventional technology as shown in Fig. 9, the electronic unit 60 has a connector 61 screwed directly into a housing 62 by bolts 63. The connector 61 is connected via a lead wire to a circuit board (not shown) accommodated in the housing 62. In yet another example of conventional electronic unit 70 as shown in Fig. 10A, the connector 71 is disposed in a rectangular opening 73 formed through a housing 72 so as to project out from the housing 72. The connector 71 is connected via a lead wire to the circuit board (not shown) accommodated in the housing 72. As shown in Fig. 10B, a space is formed between the opening 73 and the outer periphery of the connector 71, that is small enough to be protected against the entrance of foreign objects into the housing 72.

Japanese Patent Application Publication No. 2009-70855 discloses an electronic unit having a printed circuit board that is accommodated in a housing and has a connector. Apart of the connector is exposed outside the housing through an opening formed by assembled upper case and lower case of the housing. A recess and a projection are formed around the connector, and a projection and a recess are formed in the upper case and the lower case, respectively. The projection of the upper case is inserted into the recess in the connector and the projection of the connector is inserted into the recess of the lower case, a waterproofing seal member interposed between the respective projections and their corresponding recesses.

In the conventional electronic unit 50, however, the wire harness 52 needs to be provided to connect the circuit board in the housing 51 with the connector 53, which increases the number of parts and also increases the size of the electronic unit 50. Furthermore, the wire harness 52 needs additional processing and assembling step to mount the wire harness 52 to the housing 51. In the electronic unit 60 in which the connector 61 is directly mounted into the housing 62 by the bolt 63, the number of parts is increased and extra bolt tightening operation is needed. In the electronic unit 70, strict dimensional tolerance needs to be set for parts so as to maintain the desired small space G between the opening 73 of the housing 72 and the outer surface of the connector 71. Especially, the housing 72 used as a component of the electronic unit 70 restricts the assembling direction, thereby posing restrictions on designing of the electronic unit 70. In the electronic unit 60 and the electronic unit of the above-cited Publication in which the connector is directly mounted to the housing, the vibration transmitted to the housing is transmitted to the connector directly and may cause damage to the connector. Furthermore, the connector may be damaged by the heat transmitted to the housing because the housing and the connector have different coefficients of thermal expansion. In these electronic units, therefore, it is preferable to provide a space between the connector and the housing. US2008/0045061 discloses an electronic unit according to the preamble of claim 1. The present invention, which has been made in light of the problems mentioned above, is directed to providing an electronic unit that can prevent a wire from entering in the housing of the electronic unit through a space between the housing and the connector while absorbing the tolerance of components.

### SUMMARY OF THE INVENTION

In accordance with an aspect of the present invention, there is provided an electronic unit, according to claim 1, including a circuit board, a connector and a housing. The connector is electrically connected to the circuit board through a lead wire. The housing accommodates therein the circuit board having an opening through which a part of the connector is exposed outside the housing, and a clearance is formed between an edge portion of the opening of the housing and the connector. The electronic unit further includes an outer rib, an inner rib and a projection. The inner rib is formed on the inner side of the housing than the outer rib. The projection is inserted between the outer rib and the inner rib.

Other aspects and advantages of the invention will become apparent from the following description, taken in conjunction with the accompanying drawings, illustrating by way of example the principles of the invention.

### BRIEF DESCRIPTION OF THE DRAWINGS

The invention together with objects and advantages thereof, may best be understood by reference to the following description of the presently preferred embodiments together with the accompanying drawings in which:
Fig. 1 is a schematic cross-sectional view showing an overall structure of an electronic unit according to an embodiment of the present invention;
Fig. 2 is a fragmentary perspective view of the electronic unit in Fig. 1;
Fig. 3 is a transverse sectional view of the electronic unit taken along line A-A of Fig. 2;
Fig.4 is a perspective view showing a connector in a state wherein the housing of the electronic unit is removed for clarity;
Fig. 5A is a fragmentary plan view of the electronic unit in an assembled state, and Fig. 5B is a side view of Fig. 5A
Fig. 6 is a fragmentary plan view of the electronic unit in a disassembled state and the Fig. 6B is a side view of Fig. 6B.
Fig. 7 is a fragmentary cross sectional view of an electronic unit according to another embodiment of the present invention.
Fig. 8 is a perspective view of an example of conventional electronic units.
Fig. 9 is a perspective view of another example of conventional electronic units;
Fig. 10A is a perspective view of yet another example of conventional electronic units, and Fig. 10B is a plan view of Fig. 10A.

### DETAILED DESCRIPTION OF THE EMBODIMENTS

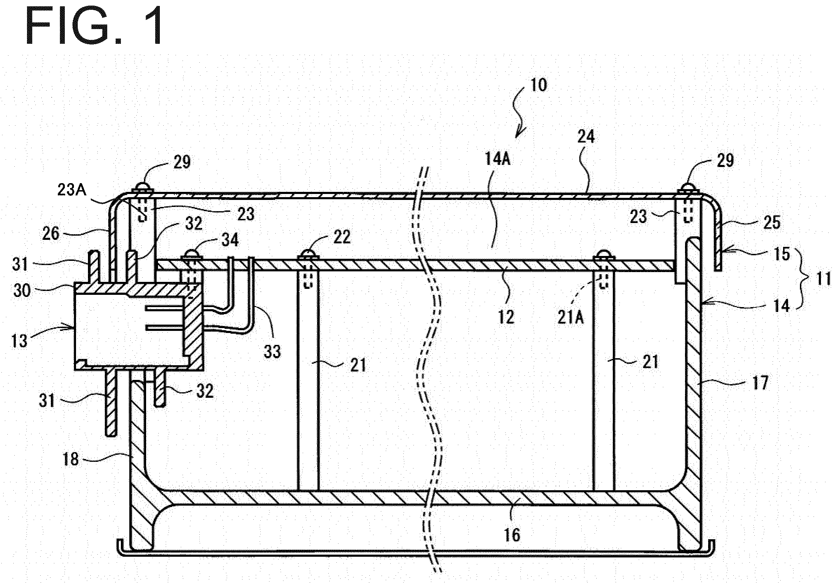

The following will describe an electronic unit of the embodiment according to the present invention with reference to Figs. 1 to 6. Referring to Fig.1, the electronic unit, which is designated by numeral 10, includes a housing 11, a circuit board 12 accommodated in the housing 11 and a connector 13 which is mounted on the circuit board 12 and a part of which is exposed outside the housing 11. The housing 11 includes a box shape housing member 14 having an opening 14Aand a cover 15 that closes the opening 14A of the housing member 14.

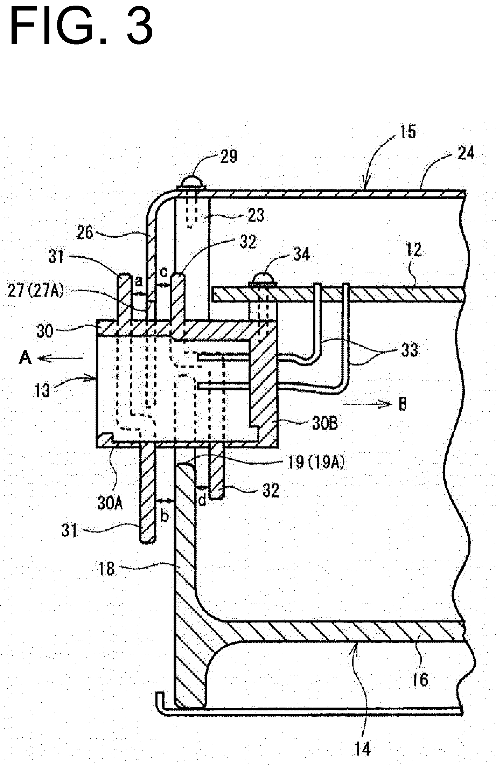

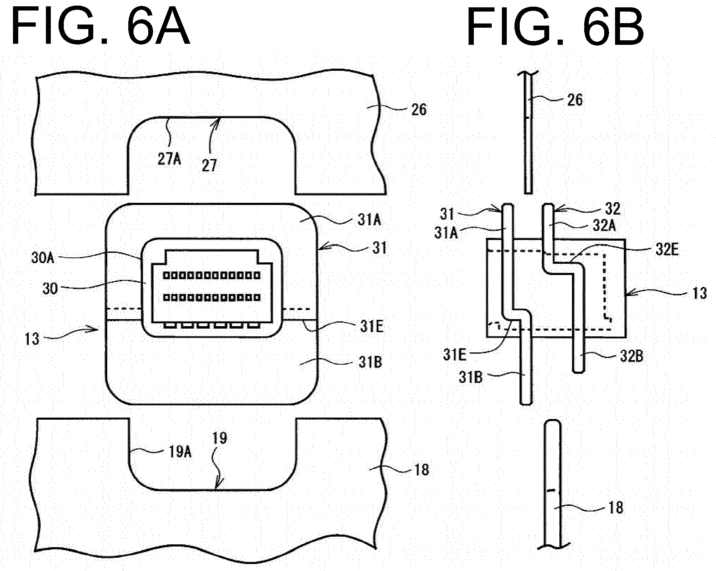

The housing member 14 of the housing 11 is formed in a boxed shape having the opening 14A. The housing member 14 includes a bottom portion 16 of a substantially rectangular shape and side walls 17, 18 extending vertically from the four sides of the rectangular bottom portion 16, respectively. The housing member 14 is formed by aluminum die casting, pressing or resin molding. A plurality of support members 21 is formed extending toward the opening 14A from the inner surface of the bottom portion 16 of the housing member 14 for mounting thereto the circuit board 12. Specifically, a screw hole 21A is formed in each of the support members 21 at the top end thereof and the circuit board 12 is fixed to the support member 21 by screws 22 screwed into the screw holes 21A. Four mounting members 23 are provided extending vertically from the four corners of the side walls 17, 18 of the housing member 14 for fixedly mounting the cover 15. A screw hole 23A is formed in each mounting member 23 at the top end thereof and the cover 15 is fixed to the mounting member 23 by screws 29. As shown in Figs. 3 and 6A, the side wall 18 of the housing member 14 that is located on the side where a part of the connector 13 is exposed has an opening 19. The opening 19 is formed in the upper part of the side wall 18 and extends to the upper end. Specifically, the opening 19 is formed by cutting an upper part of the side wall 18 in a rectangular shape so that the opening 19 has a pair of parallel sides and a side, or an edge portion 19A, extending between and perpendicular to the parallel sides.

The cover 15 is formed in a box shape having a cover body 24 that has a generally rectangular shape and side walls 25, 26 extending vertically from the four sides of the cover body 24 of the cover 15. The cover 15 is made of, for example, pressing or resin molding. As shown in Figs. 3 and 6A, the side wall 26 of the cover 15 that is located on the side where a part of the connector 13 is exposed, has therein an opening 27. The opening 27 is formed by cutting a lower part of the side wall 26 in a rectangular shape. The opening 27 has a pair of parallel sides and a side extending between and perpendicular to the parallel sides.

Electronic components (not shown) such as microcomputer, power transistor, resistor and capacitor are mounted on the circuit board 12. In the present embodiment, the connector is also mounted on the circuit board 12 for connecting the circuit board 12 to the outside of the electronic unit 10. As shown in Figs. 1, 3 and 4, the connector 13 includes a connector body 30 which is made of an insulating material, an outer rib 31 and an inner rib 32 which are formed extending from the outer periphery of the connector body 30.

The connector body 30 of the connector 13 has a bottomed square box shape having a peripheral wall 30A and a bottom portion 30B. The connector 13 is arranged in such a manner that the bottom portion 30B of the connector body 30 faces inward of the housing 11 and the opened end of the connector body 30 that is opposite from the bottom portion 30B faces outward of the housing 11. A plurality of holes (not shown) is formed through the bottom portion 30B through which a lead wire 33 is inserted. One end of the lead wire 33 is extends into the interior of the connector body 30. The other end of the lead wire 33 is inserted into a land (not shown) formed in the circuit board from the lower side thereof and connected thereto by soldering. The connector 13 is fixed to the circuit board 12 by a screw 34 or, alternatively it may be fixed by soldering.

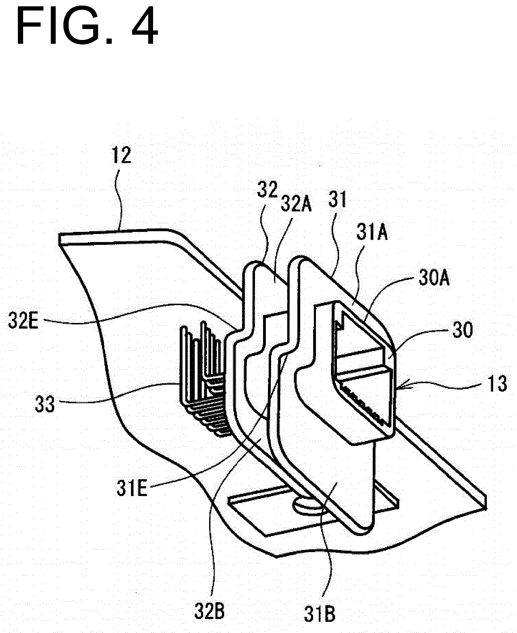

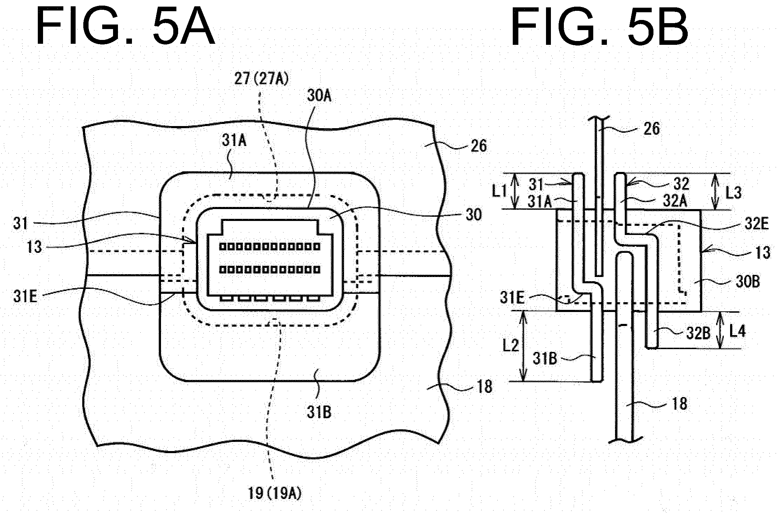

As shown in Figs. 4, 5A and 5B, the outer rib 31 is formed integrally with the connector body 30 and extends around the peripheral wall 30A of the connector body 30 on the opened end side of the connector body 30 so as to form a flange. The outer rib 31 has a rectangular shape in front view as seen from the opened end of the connector body 30, as shown in Fig. 5A, and has a predetermined thickness, as shown in Fig. 5B. The outer rib 31 includes an upper portion 31Athat is located adjacent to the cover 15 and a lower portion 31 B that is located adjacent to the housing member 14 of the housing 11. A step 31 E is formed in the outer rib 31 so that the lower portion 31 B of the outer rib 31 is located inward of the upper portion 31A thereof. The dimension L2 of the lower portion 31 B of the outer rib 31 as measured from the bottom of the connector body 30 to the lower end of the lower portion 31 B is greater than the dimension L1 of the upper portion 31A as measured from the top of the connector body 30 to the upper end of the upper portion 31 A, as shown in Fig. 5B.

As shown in Figs. 4 and 5B, the inner rib 32 is formed integrally with the connector body 30 and extends around the peripheral wall 30A of the connector body 30 on the opened end side of the connector body 30 so as to form a flange. The inner rib 32 has a rectangular shape in front view as seen from the opened end of the connector body 30 and has a predetermined thickness. The inner rib 32 includes an upper portion 32A that is located adjacent to the cover 15 and a lower portion 32B that is located adjacent to the housing member 14 of the housing 11. A step 32E is formed in the inner rib 32 so that the lower portion 32B of the inner rib 32 is located inward of the upper portion 32A. As is clear from Fig. 5B, the dimension L3 of the upper portion 32A of the inner rib 32 as measured from the top of the connector body 30 to the upper end of the upper portion 32A is substantially the same as the dimension L4 of the lower portion 32B as measured from the bottom of the connector body 30 to the lower end of the lower portion 32B. In addition, L1 and L3 are substantially the same. Though, in the upper side of the connector body 30, the dimension L1 of the upper portion 31A of the outer rib 31 and the dimension L3 of the upper portion 32A of the inner rib 32 are substantially the same, in the lower portion of the connector body 30, the dimension L2 of the lower portion 31 B of the outer rib 31 is larger than the dimension L4 of the lower portion 32B of the inner rib 31. In other words, an outer periphery of the outer rib 31 is at least partially farther from the connector body 30 than an outer periphery of the inner rib 32. As shown in Figs 4 and 5B, the step 32E of the inner rib 32 is formed at a position that is higher than the step 31 E of the outer rib 31.

As shown in Figs. 3, 5A and 5B, the upper part of the side wall 18 of the housing member 14 is arranged between the upper portion 31 A of the outer rib 31 and the upper portion 32A of the inner rib 32. A predetermined clearance is maintained between the edge portion 19A of the opening 19 of the side wall 18 and the peripheral wall 30A of the connector body 30. A clearance B between the side wall 18 and the lower portion 31 B of the outer rib 31 and a clearance D between the side wall 18 and the lower portion 32B of the inner rib 32 are set small enough to prevent an object such as a wire from entering into the housing 11. Thus, the connector 13 is not in contact with the side wall 18.

The side wall 26 of the cover 15 is arranged between the upper portion 31A of the outer rib 31 and the upper portion 32A of the inner rib 32. A predetermined clearance is maintained between the edge portion 27A of the opening 27 of the side wall 26 and the peripheral wall 30A of the connector body 30. In addition, a clearance A is formed between the side wall 26 and the upper portion 31 A of the outer rib 31 and a clearance C is formed between the side wall 26 and the upper portion 32A of the inner rib 32, respectively. These clearances A and B are set small enough to prevent a wire from entering into the housing 11. Thus, the connector 13 is clear of the side wall 26.

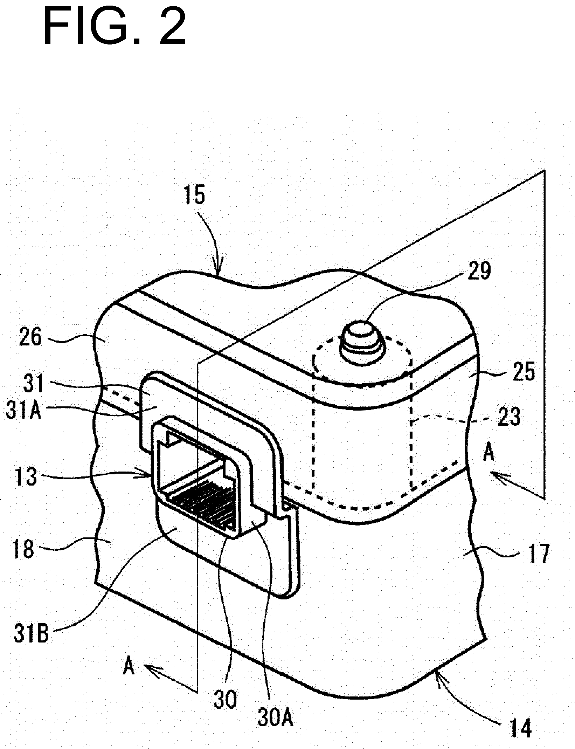

The side wall 18 and the side wall 26 that are disposed in the space between the outer rib 31 and the inner rib 32 correspond to the projection of the present invention. In the state of Fig. 5B that the side walls 18, 26 are disposed between the outer rib 31 and the inner rib 32, the side wall 26 is disposed outward of the side wall 18. As shown in Fig. 2, the side walls 25 of the cover 15 are positioned outward of the side walls 17 of the housing member 14. This enables the cover 15 to be mounted on the housing member 14 easily and also to prevent the ingress of water from above. As shown in Figs. 5A and 5B, the upper end of the side wall 18 and the lower end of the side wall 26 are overlapped with each other on the side of the connector body 30. As shown in Fig. 2, the side walls 17 of the housing member 14 and the side walls 25 of the cover 15 are also overlapped with each other around the three sides of the connector body 30. Such arrangement of the side walls 17, 25 also prevents foreign objects from entering into the housing member 14.

The assembling procedure of the electronic unit 10 will be now described. Firstly, the housing member 14 and the circuit board 12 provided with the connector 13 are prepared. The circuit board 12 is set so that the opening 19 of the side wall 18 is positioned between the outer rib 31 and the inner rib 32 of the connector 13 mounted to the circuit board, and the circuit board 12 is fixed to the support member 21 by the screws 22. Then, the cover 15 is set in a manner that the opening 27 of the side wall 26 of the cover 15 is positioned between the outer rib 31 and the inner rib 32 of the connector 13, and the cover 15 is fixed to the mounting members 23 by the screws 29.

The electronic unit 10 according to the above-described embodiment offers the following effects. The electronic unit 10 has the outer rib 31 and the inner rib 32 that are provided around the connector body 30, and a part of the side wall 18 of the housing member 14 and a part of the side wall 26 of the cover 15 are positioned between the outer rib 31 and the inner rib 32. The predetermined clearance is maintained between the edge portion 19A of the opening 19 of the side wall 18 and the peripheral wall 30A of the connector body 30. In addition, the clearance B between the side wall 18 and the lower portion 31 B of the outer rib 31 and the clearance D between the side wall 18 and the lower portion 32B of the inner rib 32 are set small enough to prevent foreign objects from entering into the housing 11.

Furthermore, the predetermined clearance is maintained between the edge portion 27A of the opening 27 of the side wall 26 and the peripheral wall 30A. The clearance A between the side wall 26 and the upper portion 31 A of the outer rib 31 and the clearance C between the side wall 26 and the upper portion 32A of the inner rib 32 are set small enough to prevent foreign objects from entering into the housing 11.

If the connector 13 is displaced by moving in direction O, as shown in Fig. 3, the clearances A, B become larger while the clearances C, D becomes smaller. On the other hand, if the connector 13 is displaced by moving in direction I, the clearances C, D become larger while the clearances A, B become smaller. Thus, the housing 11 is protected against the entrance of foreign objects in both situations. The provision of the ribs on both outer and inner sides of the housing 11, i.e. the outer rib 31 and the inner rib 32, prevents foreign objects such as wire from entering into the housing 11 even if the connector is moved in the direction O or the direction I, because the clearances A, B and the clearances C, D are changed in a complementary manner.

In the electronic unit 10 of the present embodiment, the outer rib 31 and the inner rib 32 are integrally formed with the connector body 30 in the form of a flange extending outward from the outer periphery of the connector body 30 and the side wall 18 of the housing member 14 and the side wall 26 of the cover 15 are disposed in the space between the outer rib 31 and the inner rib 32, as a result of which the degree of freedom in designing an electronic unit is improved because parts tolerance becomes less critical.

As shown in Fig. 5B, the connector body 30 is so configured that the dimension L2 of the lower portion 31 B of the outer rib 31 is larger than the dimension L4 of the lower portion 32B of the inner rib 32. This prevents foreign object such as a wire from entering into the housing 11, even if there exists an error in the dimension of the space between the ribs 31, 32 and the side wall 18 and that of the space between the edge portion 19A of the opening 19 and the peripheral wall 30A.

The step 31 E is formed in the outer rib 31 between the upper portion 31A and the lower portion 31 B thereof, and the step 32E is formed in the inner rib 32 between the upper portion 32A and the lower portion 32B thereof. The formation of the steps 31 E, 32E increases the strength of the outer rib 31 and the inner rib 32, respectively.

The side walls 18, 26 are inserted between the outer rib 31 and the inner rib 32 of the connector body 30 in such an arrangement that the side wall 18 is located inward of the side walls 26, or the side wall 26 is outward of the side wall 18, as shown in Fig. 5B. The entire circumference of the cover 15 (side walls 25) is positioned outward of the side walls 17 of the housing member 14. This enables the cover 15 to be mounted to the housing member 14 at the opening 14A thereof with ease. The upper end of the side wall 18 and the lower end of the side wall 26 are overlapped with each other on the side of the connector body 30. The side wall 17 of the housing member 14 and the side wall 25 of the cover 15 are overlapped with each other around the circumference of the electronic unit 10 other than the side of the electronic unit 10 having the connector body 30, which helps to protect the electronic unit 10 against the entrance of foreign objects in the housing 11.

The connector 13 is arranged in a non-contact state with respect to the housing member 14 and the cover 15 with the side wall 18 of the housing member 14 and the side wall 26 of the cover 15 disposed between the outer rib 31 and the inner rib 32 that are formed around the connector body 30. This can suppress the transmission of the vibration and the heat to the connector 13 from the housing 11 of the electronic unit 10, thus protecting the connector 13 against damage due to such vibration and heat.

The present invention is not limited to the above-described embodiment, but it may be modified in various manners within the scope of the invention, as exemplified below.

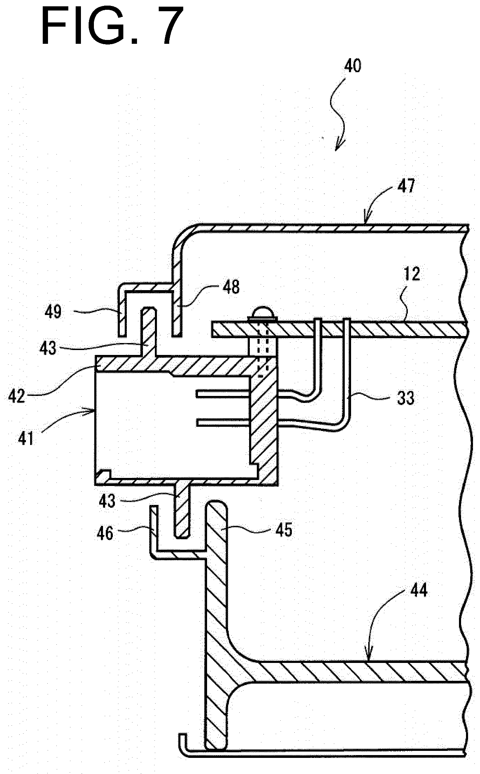

Although, in the present embodiment, the outer rib 31 and the inner rib 32 are integrally formed with the connector body 30 and the side wall 18 of the housing member 14 and the side wall 26 of the cover 15, which serve as the projection of the present invention, the outer rib and the inner rib may be provided to the housing member and the cover and the projection may be provided to the connector body. In an alternative embodiment of an electronic unit 40 shown in Fig.7, the connector body 42 of the connector 41 of the electronic unit 40 has a flange-like projection 43 that is formed integrally with the connector body 42 around the periphery thereof. The housing member 44 has an outer rib 46 and an inner rib 45 so as to have the projection 43 disposed therebetween. The inner rib 45 also serves as a part of the side wall of the housing member 44. The cover 47 has an outer rib 49 and an inner rib 48 so as to have the projection 43 disposed therebetween. The inner rib 48 is formed to serve as a part of the wall of the cover 47. In assembling of the electronic unit 40, with the lower portion of the projection 43 that is formed with the connector body 42 inserted in the space between the outer rib 46 and the inner rib 45 of the housing member 44, the upper portion of the projection 43 may be inserted into the space between the outer rib 49 and the inner rib 48 of the cover 47.

Although the outer rib 31 and the inner rib 32 are integrally formed with the connector body 30 in the present embodiment, the outer rib 31 and the inner rib 32 may be formed separately and fixed to the connector body 30 individually by an adhesive.

## Claims

1. An electronic unit (10) comprising:
a circuit board (12);
a connector (13) electrically connected to the circuit board (13) through a lead wire (33); and
a housing (11) accommodating the circuit board (12) having an opening through which a part of the connector (13) is exposed outside the housing (11), wherein a clearance is formed between an edge portion (19A) of the opening (19) and the connector (13);
**characterized in that**
the housing includes a housing member (14) that has side walls (17, 18) and a cover (15) including side walls (25, 26),
wherein the connector (13) includes a connector body 30), an outer rib (31) and an inner rib (32) that is formed on the inner side of the housing (11) than the outer rib (31);
wherein the outer rib (31) includes an upper portion (31A) that is located adjacent to the cover (15) and a lower portion (31 B) that is located adjacent to the housing member (14), and the inner rib (32) includes an upper portion (32A) that is located adjacent to the cover (15) and a lower portion (32B) that is located adjacent to the housing member (14),
wherein a step (31 E) is formed in the outer rib (31) so that the lower portion (31 B) of the outer rib (31) is located inward if of the upper portion (31 A), and a step (32E) is formed in the inner rib (32) so that the lower portion (32B) of the inner rib (32) is located inward of the upper portion (32A),
wherein the side wall (18) of the housing member (14) and the side wall (26) of the cover (15) serve as projections and are overlapped with each other on the side of the connector body (30),
wherein the projections (18, 26) are inserted between the outer rib (31) and the inner rib (32) where the step (31 E) of the outer rib (31) and the step (32E) of the inner rib (32) are disposed.

2. The electronic unit according to claim 1, **characterized in that** the outer rib (31) and the inner rib (32) that are formed on the connector body (30), wherein an outer periphery of the outer rib (31) is at least partially farther from the connector body (30) than an outer periphery of the inner rib (32).

## Patentansprüche

1. Elektrische Einheit (10) mit:
einer Leiterplatte (12);
einem Steckverbinder (13), der über einen Zuleitungsdraht (33) elektrisch mit der Leiterplatte (13) verbunden ist; und
einem Gehäuse (11), das die Leiterplatte (12) aufnimmt, mit einer Öffnung (19) durch die ein Teil des Steckverbinders (13) außerhalb des Gehäuses (11) freiliegt, wobei zwischen einem Randabschnitt (19A) der Öffnung (19) und dem Steckverbinder (13) ein Zwischenraum ausgebildet ist;
**dadurch gekennzeichnet, dass**
das Gehäuse (11) ein Gehäuseelement (14) enthält, das Seitenwände (17, 18) und eine Abdeckung (15), welche Seitenwände (25, 26) enthält, hat,
wobei der Steckverbinder (13) einen Steckverbindungskörper (30), eine äußere Rippe (31) und eine innere Rippe (32), die an der Innenseite des Gehäuses (11) wie die äußere Rippe (31) ausgebildet ist, enthält;
wobei die äußere Rippe (31) einen oberen Abschnitt (31A) enthält, der sich neben der Abdeckung (15) befindet und einen unteren Abschnitt (31 B), der sich neben dem Gehäuseelement (14) befindet, und die innere Rippe (32) einen oberen Abschnitt (32A) enthält, der sich neben der Abdeckung (15) befindet und einen unteren Abschnitt (32B), der sich neben dem Gehäuseelement (14) befindet,
wobei eine Stufe (31 E) in der äußeren Rippe (31) ausgebildet ist, so dass der untere Abschnitt (31 B) der äußeren Rippe (31) innerhalb des oberen Abschnitts (31A) angeordnet ist, und eine Stufe (32E) in der inneren Rippe (32) ausgebildet ist, so dass der untere Abschnitt (32B) der inneren Rippe (32) innerhalb des oberen Abschnitts (32A) angeordnet ist,
wobei die Seitenwand (18) des Gehäuseelements (14) und die Seitenwand (26) der Abdeckung (15) als Vorsprünge dienen und mit jeder anderen auf der Seite des Steckverbindungskörpers (30) überlappt,
wobei die Vorsprünge (18, 26) zwischen der äußeren Rippe (31) und der inneren Rippe (32) eingefügt sind, wo die Stufe (31 E) der äußeren Rippe (31) und die Stufe (32E) der inneren Rippe (32) angeordnet sind.

2. Die elektronische Einheit nach Anspruch 1, **dadurch gekennzeichnet, dass** die äußere Rippe (31) und die innere Rippe (32), die auf dem Steckverbindungskörper (30) ausgebildet sind, wobei ein äußerer Rand der äußeren Rippe (31) zumindest teilweise weiter von dem Steckverbindungskörper (30) entfernt ist als ein äußerer Rand der inneren Rippe (32).

## Revendications

1. Unité électronique (10), comprenant :
un circuit imprimé (12) ;
un connecteur (13) relié de manière électrique au circuit imprimé (13) par l'intermédiaire d'un fil électrique (33) ; et
un boîtier (11) recevant le circuit imprimé (12) ayant une ouverture à travers laquelle une partie du connecteur (13) est exposée à l'extérieur du boîtier (11), où un espace est formé entre une partie de bord (19A) de l'ouverture (19) et le connecteur (13) ;
**caractérisée en ce que** :
le boîtier comprend un élément de boîtier (14) qui possède des parois latérales (17, 18) et un couvercle (15) comprenant des parois latérales (25, 26),
où le connecteur (13) comprend un corps de connecteur (30), une nervure externe (31) et une nervure interne (32) qui est formée sur le côté interne du boîtier (11) que la nervure externe (31) ;
où la nervure externe (31) comprend une partie supérieure (31A) qui est située adjacente au couvercle (15) et une partie inférieure (31B) qui est située adjacente à l'élément de boîtier (14), et la nervure interne (32) comprend une partie supérieure (32A) qui est située adjacente au couvercle (15) et une partie inférieure (32B) qui est située adjacente à l'élément de boîtier (14),
où un échelon (31E) est formé dans la nervure externe (31) de sorte que la partie inférieure (31B) de la nervure externe (31) soit située vers l'intérieur de la partie supérieure (31A) et un échelon (32E) est formé dans la nervure interne (32) de sorte que la partie inférieure (32B) de la nervure interne (32) soit située vers l'intérieur de la partie supérieure (32A),
où la paroi latérale (18) de l'élément de boitier (14) et la paroi latérale (26) du couvercle (15) servent de projections et se chevauchent l'une à l'autre sur le côté du corps de connecteur (30),
où les projections (18, 26) sont insérées entre la nervure externe (31) et la nervure interne (32) où sont agencés l'échelon (31E) de la nervure externe (31) et l'échelon (32E) de la nervure interne (32).

2. Unité électronique selon la revendication 1, **caractérisée en ce que** la nervure externe (31) et la nervure interne (32) qui sont formées sur le corps de connecteur (30), où une périphérie externe de la nervure externe (31) est au moins partiellement plus éloignée du corps de connecteur (30) qu'une périphérie externe de la nervure interne (32).
